# EUROPEAN PATENT APPLICATION

(11) **EP 1 939 643 A2**
(43) Date of publication of application: **02.07.2008**
(21) Application number: 07250791.6
(22) Date of filing: 26.02.2007
(51) Int. Cl.: G01R 33/02

(54) **Apparatus for a magnetic field detector holding assembly for a pass-through flux (PTF) measurement stand**

(30) Priority: 20.12.2006 US 641877
(71) Applicant: Heraeus, Inc., Chandler AZ 85226 (US)
(72) Inventor: Rogers, Raymond D., Phoenix, AZ 85019 (US)
(74) Representative: Hill, Justin John

(57) **Abstract**

The present invention relates to an apparatus for a magnetic field detector holding assembly for manually-operated or automated pass-through flux (PTF) measurement stands for measuring sputter targets. The magnetic field detector holding assembly has an insert with a longitudinal opening, where the opening of the insert allows a magnetic field detector to be located. At least one fastener passes through at least one opening in the magnetic field detector holding apparatus, where the fastener is adapted to be adjusted to mechanically couple with the insert so as to hold the insert at a predetermined location within the magnetic field holding assembly. The insert prevents the magnetic field detector from being damaged by over-tightening of the fasteners, and also prevents scratching of the surface of a sputter target to be tested. The magnetic field detector holding assembly can be used by manually operated mechanical PTF stands or automated PTF stands.

## Description

### BACKGROUND

### Field

The present invention is directed to an apparatus for a magnetic field detector holding assembly for a Pass-Through Flux (PTF) measurement stand. More particularly, the present invention relates to an apparatus for a magnetic field detector holding assembly for manually-operated or automated pass-through flux measurement stands.

### Background

Sputtering processes are widely used for the deposition of thin films of material onto desired substrates. A typical sputtering system includes a source for generating an electron or ion beam, a target that comprises a material to be atomized and a substrate onto which the sputtered material is deposited. The process involves bombarding the target material with an electron or ion beam at an angle that causes the target material to be sputtered or eroded. The sputtered target material is deposited as a thin film or layer on the substrate. The target materials for sputtering process range from pure metals to ever more complicated alloys.

Magnetron sputtering involves the arrangement of permanent or electromagnets behind a target material (cathode), and applying a magnetic field to the target. The applied magnetic field transmits through the target and focuses a discharge plasma onto the front of the target. The target front surface is atomized with subsequent deposition of the target atoms on top of an evolving thin film device positioned adjacent to the target.

Magnetron sputtering of magnetic target materials is very prevalent in the electronics industry, particularly in the fabrication of semiconductor and data storage devices. Due to the soft magnetic nature of magnetic target alloys, there is considerable shunting of the applied magnetic field in the bulk of the target. This in turn results in reduced target utilization due to focusing of the transmitted magnetic field in the erosion groove formed as a result of the shunting. This focusing effect is exacerbated with increasing material permeability (which corresponds to decreasing material PTF).

Reducing target material permeability promotes a less severe erosion profile which enhances target material utilization and subsequently contributes to a reduction in material cost. The presence of severe target erosion profiles also promotes a point source sputtering phenomena which can result in less than optimum deposited film thickness uniformity. Therefore, decreasing target material permeability has the added benefit of increasing deposited film thickness uniformity.

The PTF of a sputter target is defined as the ratio of transmitted magnetic field to applied magnetic field. A PTF value of 100% is indicative of a non-magnetic material where none of the applied field is shunted through the bulk of the target. The PTF of magnetic target materials is typically specified in the range of 0 to 100%, with the majority of commercially produced materials exhibiting values between 30 to 100%.

There are several different techniques for measuring PTF. One technique involves placing a 4.4 (+/-0.4) kilogauss bar magnet in contact on one side of the target material and monitoring the transmitted field using an axial Hall probe in contact on the other side of the target material. The maximum value of the magnetic field transmitted through the bulk of the target divided by the applied field strength in the absence of the target between the magnet and probe (maintained at the same distance apart as when the target was between them) is defined as the PTF. PTF can be expressed as either a fraction or a percent.

Another technique for measuring PTF involves using a horseshoe magnet and a transverse Hall probe. The PTF values measured using different magnet and probe arrangements are found to exhibit good linear correlation for the values of magnet field strength typically utilized in the industry. The PTF measurement techniques are constructed to approximate the applied magnetic flux occurring in an actual magnetron sputtering machine. Therefore, PTF measurements have direct applicability to a target material's performance during magnetron sputtering.

Magnetic material PTF and permeability are not mutually exclusive. Rather, there is a very strong inverse correlation between PTF and maximum permeability of magnetic materials. Values of material magnetic permeability can be very precisely determined by using vibrating-sample-magnetometer (VSM) techniques in accordance with ASTM Standard A 894-89.

Presently, PTF measurement is performed with manually operated PTF stands. The ASTM F 1761-00 and ASTM F 2086-01 standards set forth test methods for pass through magnetic flux, and describe manually operated test fixtures. These test fixtures hold a magnetic field detector within a support tube with screws. If the screws are over-tightened, the magnetic field detector can easily be damaged. In addition, because of the placement of the magnetic field detector within the support tube is such that the detector extends beyond the length of the tube, the magnetic field detector can be damaged if it makes contact with a sputter target to be tested, and can also scratch the surface of the target.

Accordingly, what is needed is an improved apparatus for holding a magnetic field detector and attaching it to a PTF measurement stand. Additionally what is needed are magnetic field detector holding assemblies that do not damage the magnetic field detector or the surface of a sputter target to be measured during PTF measurement on either a manually operated or automated PTF measurement stand.

### SUMMARY

The various embodiments of the present invention address the above-described deficiencies of typical magnetic field detector attachments for PTF measurement stands.

At least one exemplary embodiment of the present invention relates to an apparatus for a magnetic field detector holding assembly for manually-operated or automated pass-through flux measurement stands for measuring sputter targets. The magnetic field detector holding assembly has an insert with a longitudinal opening, where the opening of the insert allows a magnetic field detector to be located. At least one fastener passes through at least one opening in the magnetic field detector holding apparatus, where the fastener is adapted to be adjusted to mechanically couple with the insert so as to hold the insert at a predetermined location within the magnetic field holding assembly. The insert prevents the magnetic field detector from being damaged by over-tightening of the fasteners, and also prevents scratching of the surface of a sputter target to be tested.

Various embodiments of the present invention relate to an apparatus for determining the pass through flux of a sputter target. The apparatus has a magnetic source generating a magnetic field passing through the sputter target. A magnetic field detector holding assembly has an insert with a longitudinal opening, wherein the opening of the insert allows a magnetic field detector to be located, and wherein the insert is located within the magnetic field detector holding assembly. The apparatus further has a stand configured to move one or both the sputter target or magnetic field detector holding assembly.

Various advantages of the exemplary embodiments of the present invention include, but are not limited to, holding the magnetic field detector firmly in a magnetic field detector assembly. The exemplary apparatus minimizes damage to the magnetic field detector from over-tightening of fasteners to secure the magnetic field detector within a magnetic field detector holder assembly. In addition, various exemplary embodiments of the present invention prevent the scratching of the surface of a sputter target with the magnetic field detector. The magnetic field detector is located in a predetermined location such that if the magnetic field detector holder assembly and the sputter target come into contact, the sputter target to be measured is not damaged by the contact of the magnetic field detector. In various exemplary embodiments of the present invention, the magnetic field detector is located inside a longitudinal opening in the insert and located such that magnetic field detector does not extend outside of the insert. In addition, the magnetic field detector holding assembly can be used with either a manually operated or an automated PTF measurement apparatus for measuring sputter targets.

It is understood that other embodiments of the present invention will become readily apparent to those skilled in the art from the following detailed description, wherein it is shown and described only various embodiments of the invention by way of illustration. As will be realized, the invention is capable of other and different embodiments and its several details are capable of modification in various other respects, all without departing from the spirit and scope of the present invention. Accordingly, the drawings and detailed description are to be regarded as illustrative in nature and not as restrictive.

### BRIEF DESCRIPTION OF THE DRAWINGS

Referring now to the drawings in which like reference numbers represent corresponding parts throughout:

FIGS. 1A-1C illustrate prior art mechanically operated PTF measurement test fixture stands for performing ASTM standard F 1761-00 PTF test measurements.

FIGS. 2A-2C illustrate prior art mechanically operated PTF measurement test fixture stands for performing ASTM standard F 2086-01 PTF test measurements.

FIG. 3A illustrates a side schematic view of a computer controlled PTF measurement apparatus.

FIG. 3B illustrates a top schematic view of the computer controlled PTF measurement apparatus of FIG. 3A.

FIG. 3C illustrates a partial schematic view of the computer controlled PTF apparatus of FIG. 3A showing a sputter target relative to a magnetic source and magnetic field detector.

FIG. 4 illustrates a diagram of the computer control system to control the operation of the PTF measurement apparatus of FIGS. 3A-3C.

FIG. 5A illustrates a partial schematic view of a magnetic field detector and magnetic field detector holding assembly used for the mechanical PTF measurement stands of FIGS. 1 and 2, as well as the automated PTF measurement stand of FIG. 3.

FIG. 5B illustrates a partial schematic view of an improved magnetic field detector holding assembly for the mechanical PTF measurement stands of FIGS. 1 and 2, as well as the automated PTF measurement stand of FIG. 3, according to various exemplary embodiments of the present invention.

FIG. 5C illustrates a cross-sectional view of an improved magnetic field detector holding assembly according to various exemplary embodiments of the present invention.

FIGS. 6A-6C illustrate cross-sectional views of the magnetic field detector holding assembly according to various exemplary embodiments of the present invention.

FIGS. 7A-7B illustrate cross-sectional views of the magnetic field detector insert assembly according to various exemplary embodiments of the present invention.

### DETAILED DESCRIPTION

The detailed description set forth below in connection with the appended drawings is intended as a description of various embodiments of the invention and is not intended to represent the only embodiments in which the invention may be practiced. The detailed description includes specific details for the purpose of providing a thorough understanding of the invention. However, it will be apparent to those skilled in the art that the invention may be practiced without these specific details. In some instances, well known structures and components may be shown in block diagram form or partial schematic view in order to avoid obscuring the concepts of the invention.

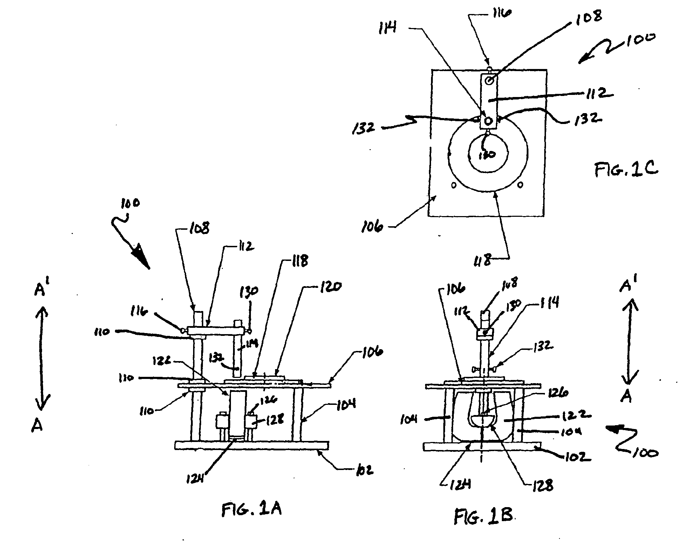

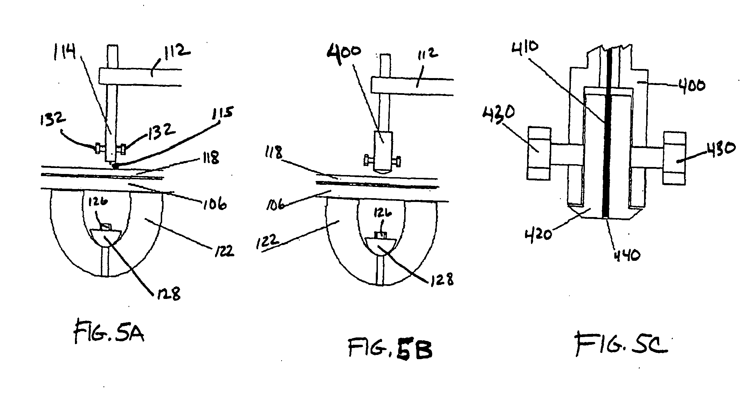

FIGS. 1A-1C illustrate prior art mechanically operated PTF measurement test fixture stands 100 for performing ASTM standard F 1761-00 PTF test measurements. Base plate 102 and table support structures 104 support target table 106. Post 108, has collars 110 to interface post 108 with target table 106. Post 108 supports cross arm 112 and support tube 114, which contains a magnetic field detector 115 (illustrated in FIG. 5A). Cross arm 112 and support tube 114 can be mechanically moved in the A or A' directions by an operator. Adjustment screw 116 can be loosened to allow movement of cross arm 112 in the A or A' directions along post 108. Once an operator has located a desired position for cross arm 112 and support tube 114 (with the magnetic field detector 115, shown in FIG. 5A) relative to the position of sputter target 118 on alignment hub 120 on target table 106, adjustment screw 116 can be tightened to secure cross arm 112 to post 108. Accordingly, sputter target 118 to be tested can be located between magnetic source 122 (e.g., a horseshoe magnet) and magnetic field detector 115 located in support tube 114. Magnetic source 122 is placed on magnetic shim 124 above base plate 102. Magnetic source 122 can be rotated about an axis manually by an operator loosening fastener 126 of magnetic clamp 128 and rotating magnetic source 122 in a clockwise or counterclockwise direction, as desired. Once magnetic source 122 is desirably located, fastener 126 can be tightened, which accordingly tightens magnet clamp 128 onto magnetic source 122.

Magnetic field detector 1 15 (shown in FIG. 5A) is located in support tube 1 14. Support tube 114 is secured to cross arm 112 by adjustable fastener 130, which is preferably a screw or other suitable fastener. Magnetic field detector 115 is secured within support tube 114 by two fasteners 132.

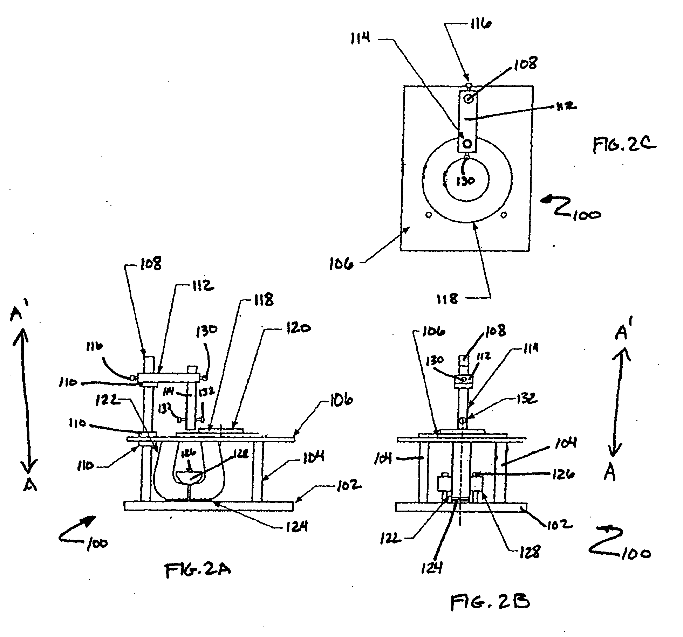

FIG. 2A-2C illustrate prior art mechanically operated PTF measurement test fixture stands 100 for performing ASTM standard F 2086-01 PTF test measurements. Stand 100 is the same as illustrated in FIGS. 1A-C and as described above. However, magnetic source 122 and magnetic field detector 115 in support tube 114 are in different orientations from their positions in FIGS. 1A-C, so as to allow for PTF measurement according to the PTF standard test measurement method as set forth in F 2086-01.

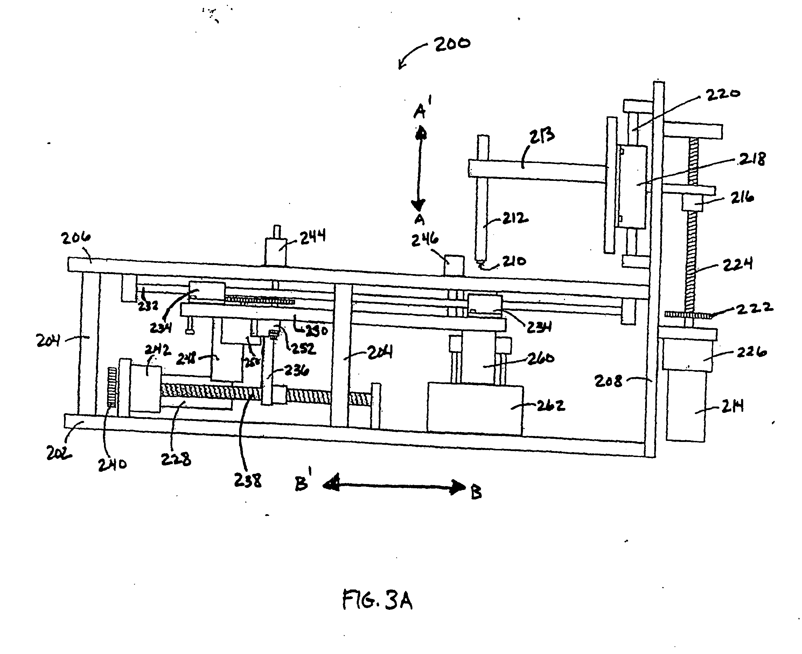

FIG. 3A illustrates a side schematic view of a computer controlled PTF measurement apparatus 200. Computer controlled PTF measurement apparatus 200 has base plate 202. Table support structures 204 are connected to base plate 202 on one end and target table 206 on the opposite end, with base plate 202 and support structures 204 supporting target table 206. Probe slide rod support structure 208 is also connected to base plate 202 and assists in supporting target table 206, in a similar manner to table support structures 204. The structural elements of the apparatus (e.g., base plate 202, table support structures 204, target table 206, probe slide rod support structure 208, etc.) utilize non-magnetic materials to allow operation of the apparatus without affecting the magnetic properties of the source magnet (e.g., source magnet 260).

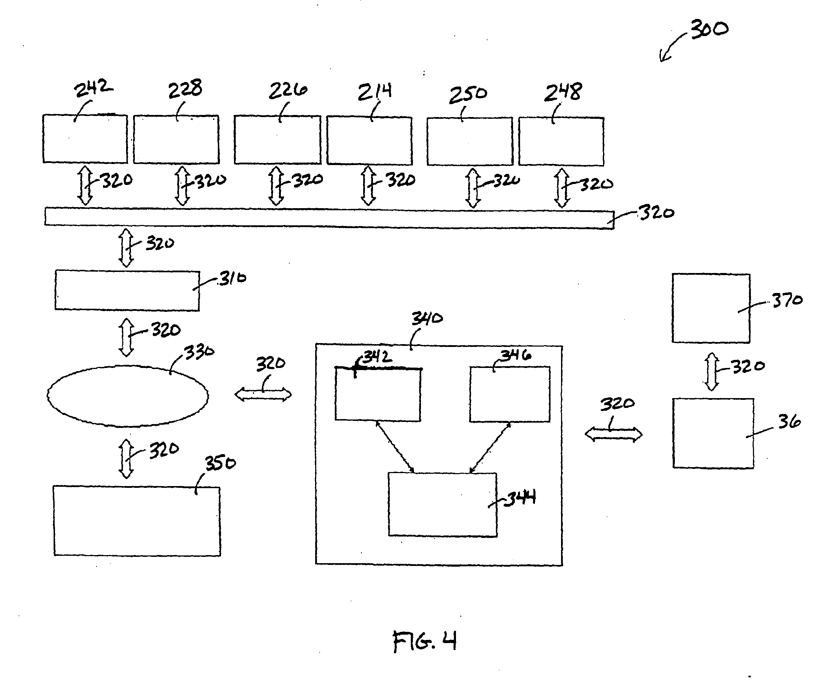

Computer controlled PTF measurement apparatus 200 enables the movement of a magnetic field detector for measuring the PTF of sputter targets. Magnetic field detector 210 is located within magnetic field detector holding assembly 212. Magnetic field detector 210 can be a Gaussmeter, Teslameter, or any other suitable magnetic field measurement device. In some exemplary embodiments, such as those illustrated in FIG. 4, the magnetic field detector may be comprised of both a magnetic field probe for detecting a magnetic field and a Gaussmeter or Teslameter for performing measurement of the magnetic field.

Magnetic field detector 210 can be moved in a vertical plane in the A or A' directions to be located in a position to measure a sputter target located on or above target table 206. Adjustment motor 214, which is controlled by computer 340 of FIG. 4, powers the movement of magnetic field detector 210 in the A or A' direction.

Cross arm 213 couples magnetic field detector holding assembly 212 with slide rod bearing assembly 218. Magnetic field detector adjustment arm 216 is connected to slide rod bearing assembly 218. Slide rod bearing assembly 218 is suspended from slide rod 220, which is affixed to slide rod support structure 208. Slide rod bearing assembly 218 can move in a vertical direction along slide rod 220, and is guided by magnetic field detector adjustment arm 216. As adjustment motor 214 turns gear 222, adjustment lead screw 224 rotates and moves magnetic field detector adjustment arm 216 in the A or A' direction. Accordingly, as adjustment motor 214 rotates gear 222 to rotate adjustment lead screw 224, magnetic field detector adjustment arm 216 moves slide rod bearing assembly 218 along slide rod 220. As magnetic field detector holding assembly 212 is connected to slide rod bearing assembly 218, magnetic field detector 210 is able to move in the A direction, and if adjustment motor 214 is reversed, magnetic field detector 210 moves in the A' direction.

Additionally, as adjustment motor 214 drives the movement of probe adjustment arm 216 in the A or A' directions, encoder 226 tracks the movement of magnetic field detector 210. Adjustment motor 214 can have a home switch that can be enabled by the movement of slide rod bearing assembly 218 along slide rod 220 into at least one predetermined position to initialize the start position of adjustment motor 214 prior to any movement or measurement of the sputter target. Thus, encoder 226 records the initial position, as well as the movement of adjustment motor 214.

Upon receiving commands from computer 340 of FIG. 4, traverse motor 228 can move rotation plate 230 in the B or B' directions to locate a sputter target beneath magnetic flux detector and above magnetic source to perform PTF measurements.

Rotation plate traverse slide 232 is mounted below target table 206. Rotation plate 230 is coupled to rotation plate traverse slide bearing assembly 234, which is suspended from rotation plate traverse slide 232. This arrangement allows rotation plate 230 to move in the B or B' direction along rotation plate traverse slide 232. Traverse rotation plate arm 236 is attached to rotation plate 230 on one end and traverse lead screw 238 on the opposite end. Traverse motor 228 rotates traverse gearing 240, which interfaces with traverse lead screw 238 to move traverse rotation plate arm 236 and rotation plate 230.

Traverse motor 228 can have a home switch that can be enabled to initialize the start position of traverse motor 228 prior to any movement or measurement of the sputter target. The home switch associated with traverse motor 228 may be activated to initialize the start position by the movement of traverse slide bearing assembly 234 on rotation plate traverse slide 232 to at least one predetermined position. Upon receipt of a command from computer 340 (illustrated in FIG. 4), traverse motor 228 turns traverse gear 240. Traverse encoder 242 records the initial position, as well as the movement of traverse motor 228. Accordingly, as traverse motor 228 drives the movement of traverse rotation plate arm 236 in the B or B' directions, traverse encoder 242 tracks the movement of rotation plate 230.

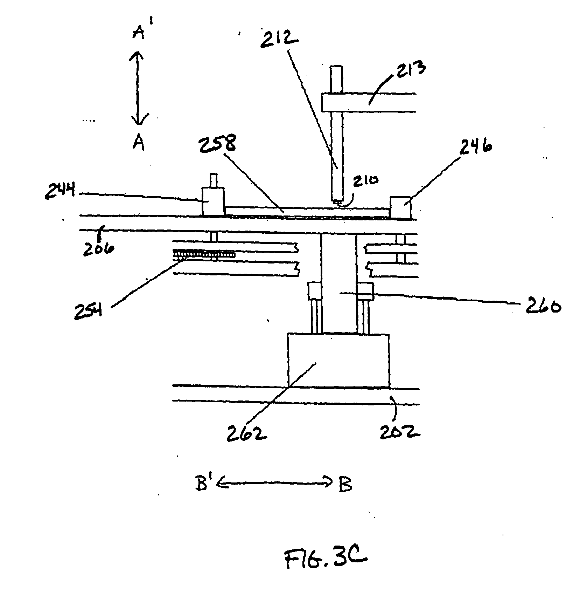

Drive wheel 244 and idler wheels 246, which are capable of holding sputter targets of various sizes, are rotatably connected to a top side of rotation plate 230. Although only one drive wheel is illustrated in FIGS. 3A-3B (e.g., drive wheel 244), additional drive wheels could be used to hold or rotate the sputter target. Additional drive gearing may be added as necessary to supply power from rotation motor 248 to the additional drive wheels. Similarly, there may be at least two idler wheels used to hold the sputter target. Oval-shaped cutouts (e.g., oval-shaped cutouts 256 as illustrated in FIG. 3C) in target table 206 allow for the pass-through of drive wheel 244 and idler wheels 246. Additional oval shaped cutouts may be added as additional drive wheels or idler wheels are added. Rotation motor 248 and rotation encoder 250 are affixed below rotation plate 230. Swivel adjustment 252 allows for movement of drive wheel 244 to permit different size sputter targets to be placed within contact of drive wheel 244 and at least two idler wheels 246. Additional swivel adjustment devices may be added to accommodate additional drive wheels. Drive gearing 254 rotates drive wheel 244 to rotate the sputter target to permit different PTF measurements at predetermined orientations.

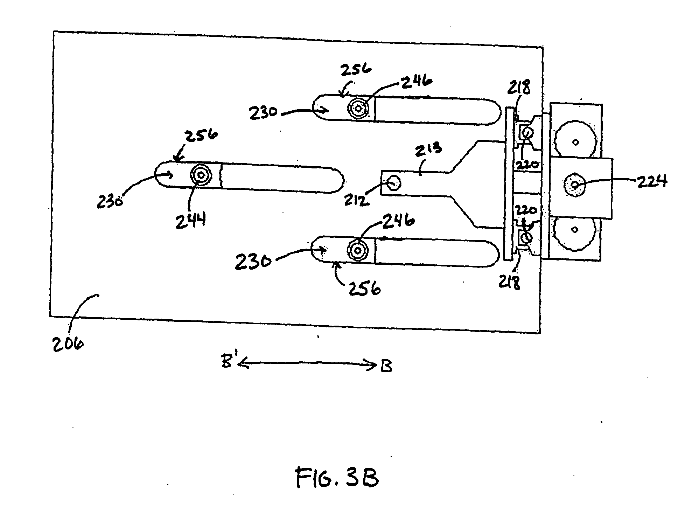

FIG. 3B illustrates a top view of computer controlled PTF apparatus 200. Oval-shaped cutouts 256 in target table 206 permit drive wheel 244 and idler wheels 246, which are mounted on rotation plate 230 to be located above the surface of target table 206 and hold a sputter target. Oval-shaped cutouts 256 allow rotation plate 230 (located below target table 206) with drive wheel 244 and idler wheels 246 to be moved in the B or B' direction, so as to accommodate different size sputter targets and to allow for measurements at different locations on a given sputter target. Movement of rotation plate 230 in the B or B' direction allows computer controlled PTF apparatus 200 to position a particular portion of a sputter target to be tested below magnetic field detector 210.

Turning to FIG. 3C, sputter target 258 is positioned between magnetic source 260 and magnetic field detector 210. Magnetic source 260 is connectively coupled to rotatable pedestal 262, with rotatable pedestal 262 being coupled to base plate 202. Magnetic source 260 is preferably a horseshoe-style magnet. An operator of computer controlled PTF apparatus 200 can rotate magnetic source 260, for example, to carry out similar test as those described by ASTM 1761 or ASTM 2086. Sputter target 258 is preferably held by drive wheel 244 and idler wheels 246. This arrangement allows sputter target 258 to be rotated by movement of drive wheel 244 (and corresponding movement of idler wheels 246), while not having direct contact with target table 206 which could scratch sputter target 258 during the rotation. As discussed above, rotation plate 230 can be moved horizontally in the B or B' direction to further position sputter target 258 below magnetic field detector 210. Magnetic field detector can be moved vertically in the A or A' direction relative to sputter target 258 and magnetic source 260.

FIG. 4 illustrates a diagram of the computer control system 300 to control the operation of the PTF measurement apparatus 200. FIG. 4 illustrates that transverse encoder 242, transverse motor 228, position encoder 226, adjustment motor 214, rotation encoder 250, and rotation motor 248 are communicatively coupled to command processor 310. Accordingly, data and commands can be exchanged between encoders 226, 242, and 250, motors 214, 228 and 248, and command processor 310. Command processor 310 is communicatively coupled by communications link 320 with communications network 330. Command processor 310 receives commands from computer 340, and instructs motors 214, 228 and 248 to accordingly turn on or off, read data collected by encoders 226, 242, and 250, or receive initialization information from the "home" or initialization switch associated with traverse motor 228 and adjustment motor 214. Computer 340 is communicatively coupled using communications link 320 with communications network 330, as is external database 350.

Database 350 can store data obtained measuring sputter targets. Data can include part number, lot number, plate number, target number, applied field, average Gauss, range of Gauss values, lowest Gauss value, highest Gauss value, or average percent PTF, any combination thereof, or any other suitable measurement or data. Database 350 can also store sputter target PTF maps generated by computer 340. Database 350 can store predetermined specifications to be utilized during the measurement of sputter targets. For example, database 350 can store data related to positions on the sputter target where measurements should be made, the number of measurements to be made, the applied field of the magnetic source, the average percent PTF, average Gauss, range in Gauss, any combination thereof, or any other suitable information.

Computer 340 can be a personal computer, laptop computer, mainframe computer, dumb terminal, Personal Digital Assistant (PDAs), wireless terminal, portable telephone, or any other form of networked personal computing device. Computer 340 can include network card 342 for interfacing with communications network 330 to transmit and receive data. Computer 340 can also have processor 344 running a program to control and collect data from transverse encoder 242, transverse motor 228, position encoder 226, adjustment motor 214, rotation encoder 250, rotation motor 248, control processor 310, database 350 or other data storage connected to communications network 330, a magnetic field detector (e.g. magnetic field detector 210, Teslameter 360, magnetic field probe 370, etc.), any combination thereof, or any other suitable device. PTF measurement data, maps of the sputter target, or other suitable data or information can be presented to an operator on display 346.

As illustrated in FIG. 4, computer 440 can be communicatively coupled to Teslameter 360 and magnetic field probe 370, where magnetic field probe 370 reads the magnetic field strength transmitted though the sputter target and Teslameter 360 interprets and quantifies the magnetic field information from the probe, and sends the collected data to computer 340. Teslameter 360 and magnetic field probe 370 may also be combined in a single device as a magnetic field detector, such as magnetic field detector 210 illustrated in FIG. 3A and FIG. 3C. Teslameter 360 may be substituted with a Gaussmeter.

FIG. 5A illustrates a partial schematic view of a magnetic field detector and magnetic field detector holding assembly used for the mechanical PTF measurement stands of FIGS. 1A-1C and FIGS. 2A-2C, as well as the automated PTF measurement stand of FIGS. 3A-3C and FIG. 4. For simplicity, the reference numerals of FIGS. 1A-1C and 2A-2C will be used in describing FIGS. 5A-5B. As illustrated in FIG. 5A, magnetic source 122 is located beneath target table 106. Magnetic source is held in a particular position by fastener 126 and magnetic clamp 128. Sputter target 118 to be tested is located on the surface, or just above the surface, of target table 106. Magnetic field detector 115 is held within support tube 114 by fasteners 132. Support tube is held by cross arm 112. which may be moved in the A or A' direction relative to sputter target 118.

FIG. 5B illustrates a partial schematic view of an improved magnetic field detector holding assembly for the mechanical PTF measurement stands of FIGS. 1 and 2, as well as the automated PTF measurement stand of FIGS. 3A-3C, according to various exemplary embodiments of the present invention. Similar to FIG. 5A, FIG. 5B illustrates magnetic source 122, target table 106, and sputter target 118. However, improved magnetic field detector holding assembly 400 of various embodiments of the present invention is shown in FIG. 5B, and in further detail in FIG. 5C.

FIG. 5C illustrates a cross-sectional view of an improved magnetic field detector holding assembly according to various exemplary embodiments of the present invention. FIG. 5C details magnetic field detector 410, is held within insert 420, which is further held within magnetic field detector holding assembly 400. Holding fasteners 430, which are preferably screws or other suitable fastener with adjustability, may be adjusted to make contact with insert 420 and retain insert 420 within magnetic field holding assembly 400. In various exemplary embodiments, holding fastener 430 may preferably be plastic screws. As illustrated in FIG. 5C, magnetic field detector 410 is positioned within insert 420 and magnetic field detector holding assembly 400 such that air gap 440 exists between one end of magnetic field detector 410 (i.e., the end of magnetic field detector 410 located adjacent from the sputter target) and one end of insert 420 (i.e., the end of insert 420 that is adjacent to the sputter target). An advantage of air gap 440 is that it minimizes possible damage sustained by magnetic field detector 410 if magnetic field detector holding assembly 400 or insert 420 makes contact with a sputter target (e.g., sputter target 118). Air gap 440 may be greater than or equal to 0.001 inches, or any other suitable gap to prevent damage of magnetic field detector 410 and allow magnetic field detector 410 to be able to detect a magnetic field. Magnetic field detector 410 may be a Teslameter, a Gaussmeter, or any other suitable device. Alternatively, magnetic field detector 410 may be a combination of a magnetic field probe, and a Telsameter or Gaussmeter.

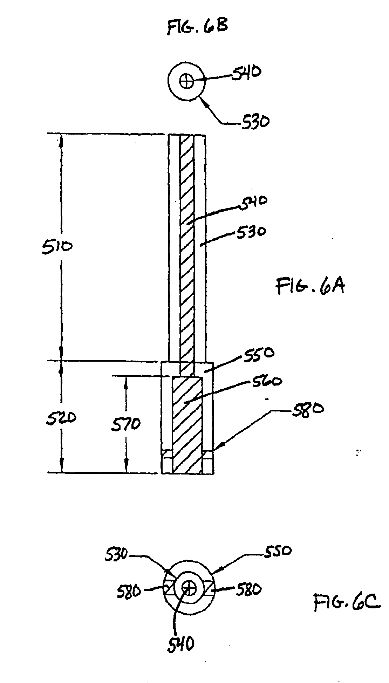

FIGS. 6A-6C illustrate cross-sectional views of the magnetic field detector holding assembly according to various exemplary embodiments of the present invention. Magnetic field detector holding assembly 500 has upper portion 510 and lower portion 520. For example, upper portion 510 may have a length of 3.00 inches, and lower portion 520 may have a length of 1.50 inches. Upper portion 510 has outer cylinder 530 and inner area 540. Inner area 540 may accommodate a magnetic field detector (e.g., magnetic field detector 410 illustrated in FIG. 5C).

FIG. 6B illustrates a cross-sectional view of upper portion 510, depicting outer cylinder 530 and inner area 540. For example, inner area 540 may have a diameter of 0.19 inches, and outer cylinder may have a diameter of 0.498 inches.

Lower portion 520 may have outer cylinder 550 and inner area 560. Inner area 560 may accommodate an insert (e.g., insert 420 of FIG. 5C) as well as a magnetic field detector magnetic field detector 410 illustrated in FIG. 5C). For example, inner area 560 may have length 570, which may be 1.30 inches. Opening 580 may be from an outer surface of outer cylinder 550 to inner area 560. Preferably, opening 580 may allow a fastener (e.g., fastener 430 illustrated in FIG. 5C) to be placed through the opening to secure an insert (e.g., insert 420 illustrated in FIG. 5C). Preferably, opening 580 may be threaded (e.g., a 10-32 tap or any other suitable threading) to accommodate a like-threaded fastener (e.g., a screw or other suitably threaded fastening device). Outer cylinders 530 and 550 are preferably made from 0.750 brass rod, although any other suitable non-magnetic material may be used. Different tolerance levels may be used in the manufacture of the elements (e.g., elements 510-580, etc.) of magnetic field detector holding assembly 500.

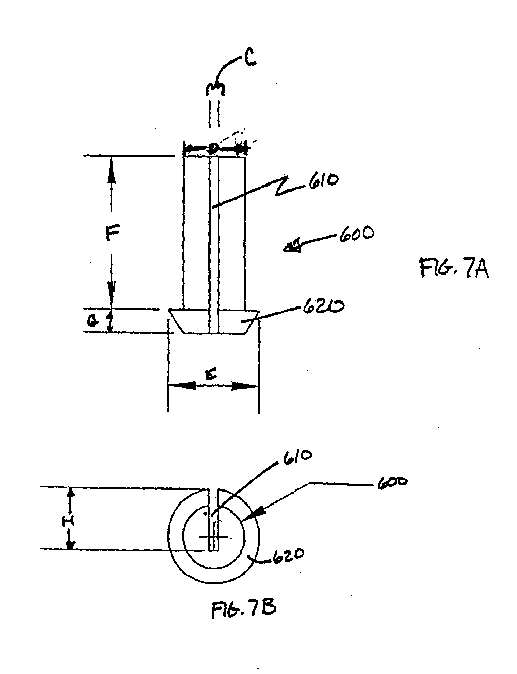

FIGS. 7A-7B illustrate cross-sectional views of the magnetic field detector insert assembly according to various exemplary embodiments of the present invention. Turning to FIG. 7A, insert 600 is shown with longitudinal opening 610, where a magnetic field detector may be preferably placed. For example, longitudinal opening 610 may have a diameter of 0.060 inches as indicated by the C-dimension in FIG. 7A, and insert 600 may have a diameter of 0.400 inches indicated by the D-dimension. End cap 620 is preferably located at one end of insert 600. For example, end cap 620 may have a diameter of 0.60 inches in the E-dimension indicated in FIG. 7A. Insert 600, for example, may have a length of 1.00 inch in the F-dimension, and end cap 620 may have a length of 0.15 inches in the G-dimension of FIG. 7A. Insert 600 or end cap 620 is preferable made from Delrin^{®}, Teflon^{®}, plastic, nylon, a non-magnetic material, or any other suitable material. An advantage of insert 600 or end cap 620 being made from Delrin^{®}, Teflon®, plastic, nylon, a non-magnetic material, or any other suitable material is that a sputter target may not be scratched if insert 600 or end cap 620 makes contact with the target. Also, insert 600 may experience some mechanical deformation from a fastener, but can minimize any potential damage to a magnetic field detector from a fastener which may be over-tightened. Longitudinal opening 610 may, for example, have a depth of 0.388 inches in the H-dimension indicated in FIG. 7B. Different tolerance levels may be used in the manufacture of the elements 600, 610, or 620.

The detailed description set forth below in connection with the appended drawings is intended as a description of various embodiments of the invention and is not intended to represent the only embodiments in which the invention may be practiced. The detailed description includes specific details for the purpose of providing a thorough understanding of the invention. However, it will be apparent to those skilled in the art that the invention may be practiced without these specific details. In some instances, well known structures and components are shown in block diagram form in order to avoid obscuring the concepts of the invention.

It is understood that the specific order or hierarchy of steps in the processes disclosed is an example of exemplary approaches. Based upon design preferences, it is understood that the specific order or hierarchy of steps in the processes may be rearranged while remaining within the scope of the present disclosure. The accompanying method claims present elements of the various steps in a sample order, and are not meant to be limited to the specific order or hierarchy presented.

The various illustrative logical blocks, modules, circuits, elements, and/or components described in connection with the embodiments disclosed herein may be implemented or performed with a general purpose processor, a digital signal processor (DSP), an application specific integrated circuit (ASIC), a field programmable gate array (FPGA) or other programmable logic component, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing components, e.g., a combination of a DSP and a microprocessor, a plurality of microprocessors, one or more microprocessors in conjunction with a DSP core, or any other such configuration.

The methods or algorithms described in connection with the embodiments disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. A storage medium may be coupled to the processor such that the processor can read information from, and write information to, the storage medium. In the alternative, the storage medium may be integral to the processor.

The previous description is provided to enable any person skilled in the art to practice the various embodiments described herein. Various modifications to these embodiments will be readily apparent to those skilled in the art, and the generic principles defined herein may be applied to other embodiments. Thus, the claims are not intended to be limited to the embodiments shown herein, but is to be accorded the full scope consistent with the language claims, wherein reference to an element in the singular is not intended to mean "one and only one" unless specifically so stated, but rather "one or more." All structural and functional equivalents to the elements of the various embodiments described throughout this disclosure that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims. No claim element is to be construed under the provisions of 35 U.S.C. §112, sixth paragraph, unless the element is expressly recited using the phrase "means for" or, in the case of a method claim, the element is recited using the phrase "step for."

## Claims

1. A magnetic field detector holding assembly apparatus for a pass-through flux measurement apparatus for measuring targets, comprising:
an insert with a longitudinal opening, wherein the opening of the insert allows a magnetic field detector to be located, and wherein the insert is located within the magnetic field detector holding assembly; and
at least one fastener, wherein the at least one fastener passes through at least one opening in the magnetic field detector holding apparatus, and wherein the fastener is adapted to be adjusted to mechanically couple with the insert so as to hold the insert at a predetermined location within the magnetic field holding assembly.

2. The apparatus of claim 1, wherein the insert is comprised of a non-metal material.

3. The apparatus of claim 2, wherein the insert is comprised of Delrin^{®}, Teflon^{®}, plastic, nylon, or a non-magnetic material.

4. The apparatus of claim 1, wherein the at least one opening in the magnetic field detector holding assembly is threaded.

5. The apparatus of claim 4, wherein the least one fastener is at least one screw that is threaded into the at least one opening.

6. The apparatus of claim 1, further comprising an air gap between one end of the magnetic field detector and one end of the insert.

7. The apparatus of claim 1, wherein the magnetic field detector holding assembly is comprised of brass or a non-magnetic material.

8. The apparatus of claim 1, wherein the magnetic field detector holding assembly has a upper portion and a lower portion, and wherein the outer diameter of the upper portion is less than or equal to the outer diameter of the lower portion.

9. The apparatus of claim 1, wherein the magnetic field detector holding assembly has an upper portion having a first inner diameter and a lower portion having a second inner diameter, and wherein the first inner diameter is less than or equal to the second inner diameter.

10. An apparatus for determining the pass through flux of a sputter target comprising:
(a) a magnetic source generating a magnetic field passing through the sputter target;
(b) magnetic field detector holding assembly having an insert with a longitudinal opening, wherein the opening of the insert allows a magnetic field detector to be located, and wherein the insert is located within the magnetic field detector holding assembly; and
(c) a stand configured to move one or both the sputter target or magnetic field detector holding assembly.

11. The apparatus of claim 10, wherein the stand is a manually operated mechanical stand.

12. The apparatus of claim 10, wherein the stand is an automated pass-through flux measurement stand.

13. The apparatus of claim 10, wherein the magnetic source is rotatable.

14. The apparatus of claim 10, wherein the insert is comprised of a non-metal material.

15. The apparatus of claim 14, wherein the insert is comprised of Delrin^{®}, Teflon^{®}, plastic, nylon, or a non-magnetic material.

16. The apparatus of claim 10, wherein the magnetic field detector holding assembly has at least one fastener, wherein the at least one fastener passes through at least one opening in the magnetic field detector holding apparatus, and wherein the fastener is adapted to be adjusted to mechanically couple with the insert so as to hold the insert at a predetermined location within the magnetic field holding assembly.

17. The apparatus of claim 16, wherein the at least one opening in the magnetic field detector holding assembly is threaded.

18. The apparatus of claim 16, wherein the least one fastener is at least one screw that is threaded into the at least one opening.

19. The apparatus of claim 10, further comprising an air gap between one end of the magnetic field detector and one end of the insert.

20. The apparatus of claim 10, wherein the magnetic field detector holding assembly is comprised of brass or non-magnetic material.

21. The apparatus of claim 10, wherein the magnetic field detector holding assembly has a upper portion and a lower portion, and wherein the outer diameter of the upper portion is ess than or equal to the outer diameter of the lower portion.

22. The apparatus of claim 10, wherein the magnetic field detector holding assembly has an upper portion having a first inner diameter and a lower portion having a second inner diameter, and wherein the first inner diameter is less than or equal to the second inner diameter.
